# EUROPEAN PATENT APPLICATION

(11) **EP 4 750 280 A1**
(43) Date of publication of application: **27.05.2026**
(21) Application number: 24847515.4
(22) Date of filing: 25.01.2024
(51) Int. Cl.: H10K 30/40, H10K 30/57, H10K 71/00

(54) **SOLAR CELL AND PREPARATION METHOD THEREFOR, PHOTOVOLTAIC MODULE AND PHOTOVOLTAIC DEVICE**

(30) Priority: 31.07.2023 CN 202310943482
(71) Applicant: Contemporary Amperex Technology Co., Limited, Ningde, Fujian 352100 (CN)
(72) Inventor: ZHANG, Zhiying, Ningde, Fujian 352100 (CN); ZHOU, Zichun, Ningde, Fujian 352100 (CN); HONG, Wanru, Ningde, Fujian 352100 (CN); GUO, Yongsheng, Ningde, Fujian 352100 (CN); OUYANG, Chuying, Ningde, Fujian 352100 (CN)
(74) Representative: Jacob, Reuben Ellis
(86) International application number: PCT/CN2024/073930
(87) International publication number: WO 2025/025546

(57) **Abstract**

The present application relates to the technical field of solar cells, and discloses a solar cell and a preparation method therefor, a photovoltaic module and a photovoltaic device. The solar cell comprises a first electrode layer, a hole transport layer, a first light absorbing layer, an interconnection layer, a second light absorbing layer, an electron transport layer and a second electrode layer which are sequentially arranged in a first direction, wherein the interconnection layer comprises an SnOₓ layer, the SnOₓ layer comprises at least three SnOₓ materials, and in the first direction, x decreases from 2 to 1 in gradient. According to the technical solution of embodiments of the present application, the performance of the solar cell is improved.

## Description

### CROSS-REFERENCE TO RELATED APPLICATIONS

The present application claims priority to Chinese Patent Application No. 202310943482.3, filed with the China National Intellectual Property Administration on July 31, 2023 and entitled "SOLAR CELL AND PREPARATION METHOD THEREOF, PHOTOVOLTAIC MODULE, AND PHOTOVOLTAIC APPARATUS", which is incorporated herein by reference in its entirety.

### TECHNICAL FIELD

The present application relates to the field of solar cell technologies, and in particular, to a solar cell and a preparation method thereof, a photovoltaic module, and a photovoltaic apparatus.

### BACKGROUND

In recent years, problems of global energy shortage and environmental pollution have become increasingly prominent, and solar cells have received increasing attention as an ideal renewable energy source. A solar cell, also referred to as a photovoltaic cell, is an apparatus that directly converts solar energy into electric energy by using a photoelectric effect or photochemical effect. Since the invention of solar cells, high photoelectric conversion efficiency has been achieved within a few years. Therefore, solar cells have a good application prospect.

With the development of solar cell technologies, higher requirements are imposed on the performance such as efficiency and stability of solar cells. Therefore, how to improve the performance of solar cells is a technical problem to be urgently resolved.

### SUMMARY

The present application is based on the foregoing topic. An objective of the present application is to provide a solar cell and a preparation method thereof, a photovoltaic module, and a photovoltaic apparatus, to improve performance of the solar cell.

According to a first aspect, a solar cell is provided, including a first electrode layer, a hole transport layer, a first light absorption layer, an interconnection layer, a second light absorption layer, an electron transport layer, and a second electrode layer that are sequentially arranged along a first direction. The interconnection layer includes an SnOₓ layer. The SnOₓ layer includes at least three types of SnOₓ materials. x gradually decreases from 2 to 1 along the first direction.

This embodiment of the present application provides the solar cell, including the first electrode layer, the hole transport layer, the first light absorption layer, the interconnection layer, the second light absorption layer, the electron transport layer, and the second electrode layer that are sequentially arranged along the first direction. The interconnection layer is disposed between the first light absorption layer and the second light absorption layer, so that the interconnection layer can not only serve as a carrier transport layer of the first light absorption layer, but also serve as a carrier transport layer of the second light absorption layer, thereby simplifying a preparation craft of the solar cell. Specifically, the interconnection layer includes the SnOₓ layer, the SnOₓ layer includes at least three types of SnOₓ materials, and x gradually decreases from 2 to 1 along the first direction. In this way, the interconnection layer can well transport carriers at the first light absorption layer and carriers at the second light absorption layer, so that efficiency of the solar cell is improved.

In a possible implementation, a thickness d1 of the SnOₓ layer satisfies: 1 nm ≤ d1 ≤ 200 nm.

In a possible implementation, the thickness d1 of the SnOₓ layer satisfies: 5 nm ≤ d1 ≤ 20 nm.

The thickness of the SnOₓ layer is set to the foregoing range, to help improve the efficiency of the solar cell.

In a possible implementation, the SnOₓ layer includes an SnO₂ layer, an SnO_{y} layer, and an SnO layer. The SnO_{y} layer is located between the SnO₂ layer and the SnO layer. The SnO layer is located between the SnO_{y} layer and the second light absorption layer. y satisfies: 1 < y < 2.

In a possible implementation, a thickness d2 of the SnO₂ layer satisfies: 1 nm ≤ d2 ≤ 50 nm.

In a possible implementation, the thickness d2 of the SnO₂ layer satisfies: 5 nm ≤ d2 ≤ 10 nm.

In a possible implementation, a thickness d3 of the SnO_{y} layer satisfies: 1 nm ≤ d3 ≤ 50 nm.

In a possible implementation, the thickness d3 of the SnO_{y} layer satisfies: 2 nm ≤ d3 ≤ 8 nm.

In a possible implementation, a thickness d4 of the SnO layer satisfies: 1 nm ≤d4 ≤50 nm.

In a possible implementation, the thickness d4 of the SnO layer satisfies: 5 nm ≤ d4 ≤ 20 nm.

The SnO₂ layer, the SnO_{y} layer, and the SnO layer are respectively set to the foregoing ranges, to help improve the efficiency of the solar cell.

In a possible implementation, the interconnection layer further includes a first hole barrier layer. The first hole barrier layer is located between the first light absorption layer and the SnOₓ layer.

In a possible implementation, the solar cell further includes a second hole barrier layer. The second hole barrier layer is located between the second light absorption layer and the electron transport layer.

In a possible implementation, a material of the first electrode layer includes a transparent conductive oxide. The transparent conductive oxide includes at least one of indium tin oxide, zinc gallium oxide, indium oxide doped with lanthanide metal, tin oxide doped with fluorine, tungsten oxide doped with indium, zinc oxide doped with indium, zinc oxide doped with boron, and zinc oxide doped with aluminum.

In a possible implementation, a material of the hole transport layer includes a P-type semiconductor, and a material of the electron transport layer includes an N-type semiconductor.

In a possible implementation, the material of the hole transport layer includes at least one of the following materials and derivatives thereof: [4-(3,6-dimethoxy-9H-carbazol-9-yl)butyl]phosphonic acid, [2-(3,6-dimethoxy-9H-carbazol-9-yl)ethyl]phosphonic acid, [4-(3,6-dibromo-9H-carbazol-9-yl)butyl]phosphonic acid, poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazol-spirobifluorene, poly(3,4-ethylenedioxythiophene)-poly(styrenesulfonate), polythiophene, nickel oxide, molybdenum oxide, cuprous iodide, and cuprous oxide. The material of the electron transport layer includes at least one of the following materials and derivatives thereof: bathocuproine, [6,6]-phenyl-C61-butyric acid methyl ester, [6,6]-phenyl-C71-butyric acid methyl ester, C60, C70, SnO_{z} (1.5 ≤ z ≤ 2), and zinc oxide.

In a possible implementation, a material of the first light absorption layer is perovskite, and a material of the second light absorption layer is perovskite.

The material of the perovskite has advantages such as high conversion efficiency, low costs, and environmental-friendly, and can be prepared into a very thin film. When the material of the perovskite is used in the solar cell, the efficiency of the solar cell can be effectively improved.

In a possible implementation, the first direction is an incident direction of sunlight. A band gap of the material of the first light absorption layer is greater than a band gap of the material of the second light absorption layer.

When the first direction is the incident direction of the sunlight, the sunlight first shines on the first light absorption layer. The band gap of the material of the first light absorption layer is set to be greater than the band gap of the material of the second light absorption layer, to help improve the efficiency of the solar cell.

In a possible implementation, a chemical formula of the perovskite in the first light absorption layer and the second light absorption layer is ABX₃. A includes at least one of CH₃(NH₂)₂⁺, CH(NH₂)₂⁺, CH₃NH₂⁺, Li⁺, Na⁺, K⁺, Rb⁺, and Cs⁺. B includes at least one of Pb⁺, Be²⁺, Mg²⁺, Ca²⁺, Sr²⁺, Ba²⁺, Zn²⁺, Ge²⁺, Fe²⁺, Co²⁺, and Ni²⁺. X includes at least one of Cl⁻, Br⁻, I⁻, SCN⁻, CNO⁻, OCN⁻, OSCN⁻, SH⁻, OH⁻, CP⁻, CN⁻, SeCN⁻, N₃⁻, and NO₂⁻.

In a possible implementation, the second electrode layer includes metal. The metal includes at least one of gold, silver, copper, aluminum, nickel, chromium, bismuth, platinum, magnesium, molybdenum, tungsten, and alloys thereof.

In a possible implementation, a material of the first hole barrier layer includes at least one of fullerene and a derivative thereof, and SnO_{z} (1.5 ≤ z ≤ 2).

In a possible implementation, a material of the second hole barrier layer includes at least one of fullerene and a derivative thereof, and SnO_{z} (1.5 ≤ z ≤ 2).

According to a second aspect, a preparation method of a solar cell is provided. The method includes: providing a first electrode layer, a hole transport layer, a first light absorption layer, an interconnection layer, a second light absorption layer, an electron transport layer, and a second electrode layer that are sequentially arranged along a first direction. The interconnection layer includes an SnOₓ layer. The SnOₓ layer includes at least three types of SnOₓ materials. x gradually decreases from 2 to 1 along the first direction.

In a possible implementation, the providing a first electrode layer, a hole transport layer, a first light absorption layer, an interconnection layer, a second light absorption layer, an electron transport layer, and a second electrode layer that are sequentially arranged along a first direction includes: providing the first electrode layer; preparing the hole transport layer at the first electrode layer; preparing the first light absorption layer at the hole transport layer; preparing the interconnection layer at the first light absorption layer; preparing the second light absorption layer at the interconnection layer; preparing the electron transport layer at the second light absorption layer; and preparing the second electrode layer at the electron transport layer.

In a possible implementation, the preparing the interconnection layer at the first light absorption layer includes: preparing the SnOₓ layer at the first light absorption layer, to form the interconnection layer.

In a possible implementation, the preparing the SnOₓ layer at the first light absorption layer includes: preparing an SnO₂ layer at the first light absorption layer, preparing an SnO_{y} layer (1 < y < 2) at the SnO₂ layer, and preparing an SnO layer at the SnO_{y} layer, to prepare the SnOₓ layer.

In a possible implementation, the preparing the SnOₓ layer at the first light absorption layer includes: depositing an SnOₓ (1 ≤ x ≤ 2) material at the first light absorption layer by using an atomic layer deposition device, to prepare the SnOₓ layer. A ratio of an element tin to an element oxygen in the SnOₓ material is adjusted during deposition of the SnOₓ material. x gradually decreases from 2 to 1 along the first direction.

In a possible implementation, a thickness d1 of the SnOₓ layer satisfies: 1 nm ≤ d1 ≤ 200 nm.

In a possible implementation, the thickness d1 of the SnOₓ layer satisfies: 5 nm ≤ d1 ≤ 20 nm.

In a possible implementation, a thickness d2 of the SnO₂ layer satisfies: 1 nm ≤ d2 ≤ 50 nm.

In a possible implementation, the thickness d2 of the SnO₂ layer satisfies: 5 nm ≤ d2 ≤ 10 nm.

In a possible implementation, a thickness d3 of the SnO_{y} layer satisfies: 1 nm ≤ d3 ≤ 50 nm.

In a possible implementation, the thickness d3 of the SnO_{y} layer satisfies: 2 nm ≤ d3 ≤ 8 nm.

In a possible implementation, a thickness d4 of the SnO layer satisfies: 1 nm ≤ d4 ≤ 50 nm.

In a possible implementation, the thickness d4 of the SnO layer satisfies: 5 nm ≤ d4 ≤ 20 nm.

According to a third aspect, a photovoltaic module is provided, including the solar cell in any one of the first aspect and the possible implementations of the first aspect, and/or including a solar cell prepared by using the preparation method in any one of the second aspect and the possible implementations of the second aspect.

According to a fourth aspect, a photovoltaic apparatus is provided, including the photovoltaic module in the third aspect.

### BRIEF DESCRIPTION OF THE DRAWINGS

To describe the technical solutions in embodiments of the present application more clearly, the following briefly describes the accompanying drawings required for describing the embodiments of the present application. It is clear that the accompanying drawings in the following descriptions show merely some embodiments of the present application, and a person of ordinary skill in the art may still derive other drawings from the accompanying drawings without creative efforts.
FIG. 1 is a schematic diagram of a solar cell according to an embodiment of the present application;
FIG. 2 is a schematic diagram of a solar cell according to an embodiment of the present application; and
FIG. 3 is a schematic diagram of a preparation method of a solar cell according to an embodiment of the present application.

### DETAILED DESCRIPTION

Hereinafter, implementations of a solar cell and a preparation method thereof, a photovoltaic module, and a photovoltaic apparatus of the present application are specifically disclosed with reference to detailed descriptions of the accompanying drawings as appropriate. However, there may be situations in which unnecessary detailed descriptions may be omitted. For example, there are situations in which detailed descriptions of well-known matters are omitted and repeated descriptions of an actually same structure are provided. Thus, the following descriptions do not become unnecessarily lengthy, to facilitate understanding by a person skilled in the art. In addition, the accompanying drawings and the following descriptions are provided for a person skilled in the art to fully understand the present application and are not intended to limit the subject matter recorded in the claims.

A "range" disclosed in the present application is defined in a form of a lower limit and an upper limit, a given range is defined by selecting a lower limit and an upper limit, and the selected lower limit and upper limit define boundaries of a particular range. The range defined in this way may include or exclude end values, and may be arbitrarily combined, that is, any lower limit can be combined with any upper limit to form a range. For example, if ranges of 60 to 120 and 80 to 110 are listed for a particular parameter, it is to be understood that ranges of 60 to 110 and 80 to 120 are also expected. In addition, if minimum range values 1 and 2 are listed, and if maximum range values 3, 4, and 5 are listed, the following ranges can all be expected: 1 to 3, 1 to 4, 1 to 5, 2 to 3, 2 to 4, and 2 to 5. In the present application, unless otherwise specified, a value range "a to b" represents an abbreviated representation of any combination of real numbers between a and b, where a and b are both real numbers. For example, a value range "0 to 5" indicates that all real numbers between "0 to 5" are listed in this specification, and "0 to 5" is only an abbreviated representation of these value combinations. In addition, when a parameter is expressed as an integer greater than or equal to 2, it is equivalent to disclosing that the parameter is, for example, an integer of 2, 3, 4, 5, 6, 7, 8, 9, 10, 11, 12, or the like.

Unless otherwise specified, all the embodiments and optional embodiments of the present application can be combined with each other form new technical solutions.

Unless otherwise specified, all technical features and optional technical features of the present application can be combined with each other to form new technical solutions.

Unless otherwise specified, all the steps in the present application can be performed in the order described or in a random order, and preferably in the order described. For example, a method includes steps (a) and (b), indicating that the method may include steps (a) and (b) performed sequentially, or may include steps (b) and (a) performed sequentially. For example, the method may further include step (c), indicating that step (c) may be added to the method in any order. For example, the method may include steps (a), (b), and (c), or may include steps (a), (c), and (b), or may include steps (c), (a), and (b).

Unless otherwise specified, "comprising" and "including" mentioned in the present application indicate open inclusion or closed inclusion. For example, "comprising" and "including" may indicate that other components not listed may further be comprised or included.

Unless otherwise specified, in the present application, the term "and/or" is inclusive. For example, the phrase "A and/or B" means "A, B, or both A and B". More specifically, any one of the following conditions satisfies the condition "A or B": A is true (or present) and B is false (or not present); A is false (or not present) and B is true (or present); or both A and B are true (or present).

Solar cells have a good application prospect due to high photoelectric conversion efficiency thereof. In the solar cell, disposition of films is crucial to performance, such as stability and efficiency, of the solar cell. Currently, to simplify a preparation craft of a solar cell and reduce a risk of degradation of the performance of the solar cell caused by craft complexity, an interconnection layer including an oxide of tin is disposed between two light absorption layers of a tandem cell, to serve as carrier transport layers of both the two light absorption layers. However, currently, all oxide materials of tin included in the interconnection layer are single-type oxides of tin, for example, SnO_{1.76} or SnO₂. The single-type oxide of tin has a limited capability of transporting carriers at the two light absorption layers, and affects the performance of the solar cell.

In view of this, an embodiment of the present application provides a solar cell. The solar cell includes a first electrode layer, a hole transport layer, a first light absorption layer, an interconnection layer, a second light absorption layer, an electron transport layer, and a second electrode layer that are sequentially arranged along a first direction. The interconnection layer includes an SnOₓ layer. The SnOₓ layer includes at least three types of SnOₓ materials. x gradually decreases from 2 to 1 along the first direction. In this way, the interconnection layer can well transport carriers at the first light absorption layer and mine carriers at the second light absorption layer, so that efficiency of the solar cell is improved.

### [Solar cell]

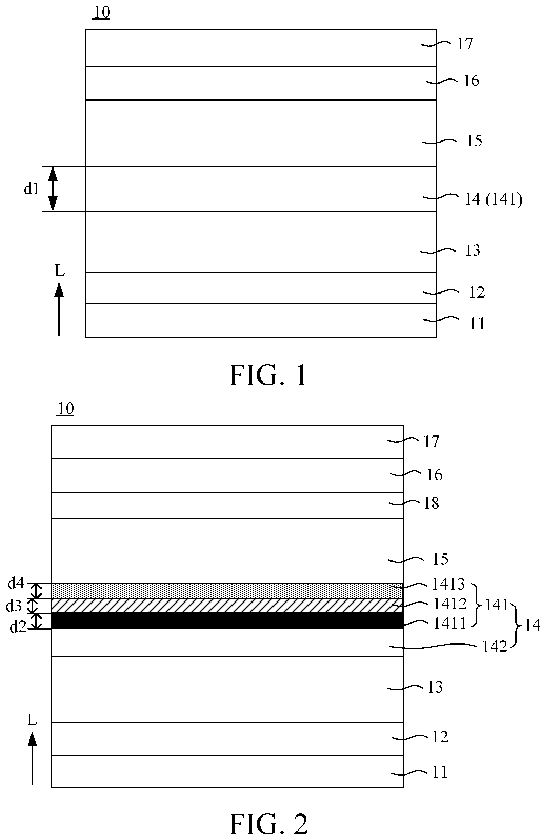

FIG. 1 is a schematic diagram of a solar cell according to an embodiment of the present application. As shown in FIG. 1, a solar cell 10 includes a first electrode layer 11, a hole transport layer 12, a first light absorption layer 13, an interconnection layer 14, a second light absorption layer 15, an electron transport layer 16, and a second electrode layer 17 that are sequentially arranged along a first direction.

The first direction may be a thickness direction of the solar cell. For example, as shown in FIG. 1, the first direction is a direction L (a direction pointed by an arrow).

The interconnection layer 14 includes an SnOₓ layer 141. The SnOₓ layer 141 includes at least three types of SnOₓ materials. x gradually decreases from 2 to 1 along the first direction.

That the SnOₓ layer 141 includes at least three types of SnOx materials, and x gradually decreases from 2 to 1 along the first direction may refer to that the SnOₓ layer 141 may include at least three film layers including the SnOₓ materials, and the SnOₓ materials at the film layers are different. For example, along the first direction, an SnOₓ material at a first SnOₓ film layer is SnO₂, an SnOₓ material at a second SnOₓ film layer is SnO_{1.5}, an SnOₓ material at a third SnOₓ film layer is SnO_{1.3}, and an SnOₓ material at a fourth SnOₓ film layer is SnO. The foregoing description is provided by using an example in which the SnOₓ layer 141 includes the four SnOx materials. However, in the technical solution of this embodiment of the present application, the SnOₓ layer 141 is not limited to including the four SnOx materials. The SnOₓ layer 141 may include three SnOₓ materials, five SnOx materials, six SnOx materials, or the like. It may be understood that, along the first direction, the SnOₓ materials at the film layers included in the SnOₓ layer 141 are different, and SnOₓ materials at a same film layer are the same.

In the technical solution of this embodiment of the present application, the SnOₓ layer 141 included in the interconnection layer 14 includes the at least three types of SnOₓ materials, and x gradually decreases from 2 to 1 along the first direction. The interconnection layer 14 of this structure can well transport carriers at the first light absorption layer 13 and carriers at the second light absorption layer 15, so that efficiency of the solar cell 10 is improved.

When sunlight shines the first light absorption layer 13 and the second light absorption layer 15, an electron-hole pair may be generated. Materials of the first light absorption layer 13 and the second light absorption layer 15 are materials absorbing light, for example, may be a material of perovskite. The material of the perovskite has advantages such as high conversion efficiency, low costs, and environmental-friendly, and can be prepared into a very thin film. When the material of the perovskite is used in the solar cell, the efficiency of the solar cell can be effectively improved.

The hole transport layer 12 is configured to transport a hole, and a material of the hole transport layer 12 includes a P-type semiconductor. The P-type semiconductor, also referred to as a hole-type semiconductor, is a semiconductor mainly conducting by using a hole with a positive charge.

The electron transport layer 16 is configured to transport an electron, and a material of the electron transport layer 16 includes an N-type semiconductor. The N-type semiconductor, also referred to as an electron-type semiconductor, is a semiconductor mainly conducting by using an electron with a negative charge.

The first electrode layer 11 and the second electrode layer 17 are conductive film layers, and the first electrode layer 11 may be connected to the second electrode layer 17 to generate a photocurrent, so as to supply power to a power consuming apparatus.

The solar cell 10 provided in this embodiment of the present application includes the first electrode layer 11, the hole transport layer 12, the first light absorption layer 13, the interconnection layer 14, the second light absorption layer 15, the electron transport layer 16, and the second electrode layer 17 that are sequentially arranged along the first direction. The interconnection layer 14 is disposed between the first light absorption layer 13 and the second light absorption layer 15, so that the interconnection layer 14 can not only serve as a carrier transport layer of the first light absorption layer 13, but also serve as a carrier transport layer of the second light absorption layer 15, thereby simplifying a preparation craft of the solar cell 10. Specifically, the interconnection layer 14 includes the SnOₓ layer 141, the SnOₓ layer 141 includes the at least three types of SnOₓ materials, and x gradually decreases from 2 to 1 along the first direction. In this way, the interconnection layer 14 can well transport the carriers at the first light absorption layer 13 and the carriers at the second light absorption layer 15, so that the efficiency of the solar cell 10 is improved.

In some embodiments, as shown in FIG. 1, a thickness d1 of the SnOₓ layer 141 satisfies: 1 nm ≤ d1 ≤ 200 nm, and optionally, 5 nm ≤ d1 ≤ 20 nm.

Specifically, the thickness d1 of the SnOₓ layer 141 may be 1 nm, 10 nm, 20 nm, 50 nm, 80 nm, 100 nm, 150 nm, 180 nm, 200 nm, or a value between any two of the foregoing values.

The thickness of the SnOₓ layer 141 is set to the foregoing range, to help improve the efficiency of the solar cell.

Optionally, in some embodiments, as shown in FIG. 2, the SnOₓ layer 141 includes an SnO₂ layer 1411, an SnO_{y} layer 1412, and an SnO layer 1413. The SnO_{y} layer 1412 is located between the SnO₂ layer 1411 and the SnO layer 1413. The SnO layer 1413 is located between the SnO_{y} layer 1412 and the second light absorption layer 15. y satisfies: 1 < y < 2.

In some embodiments, as shown in FIG. 2, a thickness d2 of the SnO₂ layer 1411 satisfies: 1 nm ≤ d2 ≤ 50 nm, and optionally, d2 satisfies: 5 nm ≤ d2 ≤ 10 nm.

Specifically, the thickness d2 of the SnO₂ layer 1411 may be 1 nm, 5 nm, 10 nm, 15 nm, 20 nm, 25 nm, 30 nm, 35 nm, 40 nm, 45 nm, 50 nm, or a value between any two of the foregoing values.

The thickness d2 of the SnO₂ layer 1411 is set to the foregoing range, to help improve performance of the cell.

In some embodiments, as shown in FIG. 2, a thickness d3 of the SnO_{y} layer 1412 satisfies: 1 nm ≤ d3 ≤ 50 nm, and optionally, d3 satisfies: 2 nm ≤ d3 ≤ 8 nm.

Specifically, the thickness d3 of the SnO_{y} layer 1412 may be 1 nm, 5 nm, 10 nm, 15 nm, 20 nm, 25 nm, 30 nm, 35 nm, 40 nm, 45 nm, 50 nm, or a value between any two of the foregoing values.

In some embodiments, as shown in FIG. 2, a thickness d4 of the SnO layer 1413 satisfies: 1 nm ≤ d4 ≤ 50 nm, and optionally, d4 satisfies: 5 nm ≤ d4 ≤ 20 nm.

Specifically, the thickness d4 of the SnO layer 1413 may be 1 nm, 5 nm, 10 nm, 15 nm, 20 nm, 25 nm, 30 nm, 35 nm, 40 nm, 45 nm, 50 nm, or a value between any two of the foregoing values.

The SnO₂ layer 1411, the SnO_{y} layer 1412, and the SnO layer 1413 are respectively set to the foregoing ranges, to help improve the efficiency of the solar cell.

In the technical solution of this embodiment of the present application, the thickness of each film layer may be measured by using a step profiler. For a specific measurement method, refer to a known measurement method of the step profiler.

Optionally, in some embodiments, as shown in FIG. 2, the interconnection layer 14 further includes a first hole barrier layer 142. The first hole barrier layer 142 is located between the first light absorption layer 13 and the SnOₓ layer 141.

The first hole barrier layer 142 can transport an electron. A material of the first hole barrier layer 142 includes at least one of fullerene and a derivative thereof, and SnO_{z} (1.5 ≤ z ≤ 2). For example, when a value of z is 2, the material of the first hole barrier layer 142 may include SnO₂.

Optionally, in some embodiments, still refer to FIG. 2, the solar cell 10 further includes a second hole barrier layer 18. The second hole barrier layer 18 is located between the second light absorption layer 15 and the electron transport layer 16.

The second hole barrier layer 18 can transport an electron. A material of the second hole barrier layer 18 includes at least one of fullerene and a derivative thereof, and SnO_{z} (1.5 ≤ z ≤ 2). For example, when a value of z is 2, the material of the second hole barrier layer 18 may include SnO₂.

In some embodiments, a material of the first electrode layer 11 includes a transparent conductive oxide. Optionally, the transparent conductive oxide includes at least one of indium tin oxide, zinc gallium oxide, indium oxide doped with lanthanide metal, tin oxide doped with fluorine, tungsten oxide doped with indium, zinc oxide doped with indium, zinc oxide doped with boron, and zinc oxide doped with aluminum.

Optionally, the material of the hole transport layer 12 includes at least one of the following materials and derivatives thereof: [4-(3,6-dimethoxy-9H-carbazol-9-yl)butyl]phosphonic acid, [2-(3,6-dimethoxy-9H-carbazol-9-yl)ethyl]phosphonic acid, [4-(3,6-dibromo-9H-carbazol-9-yl)butyl]phosphonic acid, poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazol-spirobifluorene, poly(3,4-ethylenedioxythiophene)-poly(styrenesulfonate), polythiophene, nickel oxide, molybdenum oxide, cuprous iodide, and cuprous oxide.

Optionally, the material of the electron transport layer 16 includes at least one of the following materials and derivatives thereof: bathocuproine, [6,6]-phenyl-C61-butyric acid methyl ester, [6,6]-phenyl-C71-butyric acid methyl ester, C60, C70, SnO_{z} (1.5 ≤ z ≤ 2), and zinc oxide.

In some embodiments, a material of the first light absorption layer 13 is perovskite, and a material of the second light absorption layer 15 is perovskite.

Optionally, in some embodiments, the first direction is an incident direction of sunlight, for example, the direction L (the direction pointed by the arrow) in FIG. 1 and FIG. 2. A band gap of the material of the first light absorption layer 13 is greater than a band gap of the material of the second light absorption layer 15.

The band gap refers to an energy difference between a lowest point of a conduction band and a highest point of a valence band in a semiconductor material.

Optionally, the band gap of the material of the first light absorption layer 13 ranges from 1.6 eV to 2.34 eV, and the band gap of the material of the second light absorption layer 15 ranges from 1.0 eV to 1.4 eV. For example, the material of the perovskite of the first light absorption layer 13 is bromine-iodine mixed perovskite, and the material of the perovskite of the second light absorption layer 15 is tin-lead mixed perovskite.

Optionally, in some embodiments, the material of the second light absorption layer 15 is silicon, copper indium gallium selenide, copper indium selenide, cadmium telluride, or gallium arsenide.

When the first direction is the incident direction of the sunlight, the sunlight first shines on the first light absorption layer 13. The band gap of the material of the first light absorption layer 13 is set to be greater than the band gap of the material of the second light absorption layer 15, to help improve the efficiency of the solar cell.

In some embodiments, a chemical formula of the perovskite in the first light absorption layer and the second light absorption layer is ABX₃. A includes at least one of CH₃(NH₂)₂⁺, CH(NH₂)₂⁺, CH₃NH₂⁺, Li⁺, Na⁺, K⁺, Rb⁺, and Cs⁺. B includes at least one of Pb⁺, Be²⁺, Mg²⁺, Ca²⁺, Sr²⁺, Ba²⁺, Zn²⁺, Ge²⁺, Fe²⁺, Co²⁺, and Ni²⁺. X includes at least one of Cl⁻, Br⁻, I⁻, SCN⁻, CNO⁻, OCN⁻, OSCN⁻, SH⁻, OH⁻, CP⁻, CN⁻, SeCN⁻, N₃⁻, and NO₂⁻. In this way, it is convenient to flexibly select a specific type of the perovskite based on an actual requirement.

In some embodiments, the second electrode layer 17 includes metal. Optionally, the metal includes at least one of gold, silver, copper, aluminum, nickel, chromium, bismuth, platinum, magnesium, molybdenum, tungsten, and alloys thereof.

### [Preparation method of a solar cell]

The foregoing describes the solar cell provided in the embodiments of the present application. A preparation method of a solar cell provided in an embodiment of the present application is described below, and a part similar to that in the solar cell is not described again.

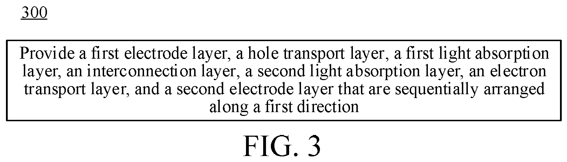

FIG. 3 shows a preparation method of a solar cell according to an embodiment of the present application. As shown in FIG. 3, the preparation method 300 includes: providing a first electrode layer, a hole transport layer, a first light absorption layer, an interconnection layer, a second light absorption layer, an electron transport layer, and a second electrode layer that are sequentially arranged along a first direction.

The interconnection layer includes an SnOₓ layer. The SnOₓ layer includes at least three types of SnOₓ materials. x gradually decreases from 2 to 1 along the first direction.

In some embodiments, the preparation method 300 includes: providing the first electrode layer; preparing the hole transport layer at the first electrode layer; preparing the first light absorption layer at the hole transport layer; preparing the interconnection layer at the first light absorption layer; preparing the second light absorption layer at the interconnection layer; preparing the electron transport layer at the second light absorption layer; and preparing the second electrode layer at the electron transport layer.

In some embodiments, the preparation method 300 includes: preparing the SnOₓ layer at the first light absorption layer, to form the interconnection layer.

In some embodiments, the preparing method 300 includes: preparing an SnO₂ layer at the first light absorption layer, preparing an SnO_{y} layer (1 < y < 2) at the SnO₂ layer, and preparing an SnO layer at the SnO_{y} layer, to prepare the SnOₓ layer.

In some embodiments, the preparing method 300 includes: depositing an SnOₓ (1 ≤ x ≤ 2) material at the first light absorption layer by using an atomic layer deposition device, to prepare the SnOₓ layer.

A ratio of an element tin to an element oxygen in the SnOₓ material is adjusted during deposition of the SnOₓ material, and x gradually decreases from 2 to 1 along the first direction.

For example, SnO₂ is first deposited; then the SnOₓ material is adjusted to SnO_{1.76}, and deposition continues to be performed; then the SnOₓ material is adjusted to SnO_{1.5}, and deposition continues to be performed; and the SnOₓ material is finally adjusted to SnO, and deposition continues to be performed, to finally form the SnOₓ layer.

In some embodiments, a thickness d1 of the SnOₓ layer satisfies: 1 nm ≤ d1 ≤ 200 nm, and optionally, 5 nm ≤ d1 ≤ 20 nm.

Specifically, the thickness d1 of the SnOₓ layer may be 1 nm, 10 nm, 20 nm, 50 nm, 80 nm, 100 nm, 150 nm, 180 nm, 200 nm, or a value between any two of the foregoing values.

The thickness of the SnOₓ layer is set to the foregoing range, to help improve efficiency and stability of the solar cell.

In some embodiments, a thickness d2 of the SnO₂ layer satisfies: 1 nm ≤ d2 ≤ 50 nm, and optionally, d2 satisfies: 5 nm ≤ d2 ≤ 10 nm.

Specifically, the thickness d2 of the SnO₂ layer may be 1 nm, 5 nm, 10 nm, 15 nm, 20 nm, 25 nm, 30 nm, 35 nm, 40 nm, 45 nm, 50 nm, or a value between any two of the foregoing values.

The thickness d2 of the SnO₂ layer is set to the foregoing range, to help improve performance of the cell.

In some embodiments, a thickness d3 of the SnO_{y} layer satisfies: 1 nm ≤ d3 ≤ 50 nm, and optionally, d3 satisfies: 2 nm ≤ d3 ≤ 8 nm.

Specifically, the thickness d3 of the SnO_{y} layer may be 1 nm, 5 nm, 10 nm, 15 nm, 20 nm, 25 nm, 30 nm, 35 nm, 40 nm, 45 nm, 50 nm, or a value between any two of the foregoing values.

In some embodiments, a thickness d4 of the SnO layer satisfies: 1 nm ≤ d4 ≤ 50 nm, and optionally, d4 satisfies: 5 nm ≤ d4 ≤ 20 nm.

Specifically, the thickness d4 of the SnO layer may be 1 nm, 5 nm, 10 nm, 15 nm, 20 nm, 25 nm, 30 nm, 35 nm, 40 nm, 45 nm, 50 nm, or a value between any two of the foregoing values.

The SnO₂ layer, the SnO_{y} layer, and the SnO layer are respectively set to the foregoing ranges, to help improve the efficiency and the stability of the solar cell.

An embodiment of the present application further provides a photovoltaic module. The photovoltaic module usually includes the foregoing solar cell, welding strips connecting a plurality of solar cells, a junction box for current transmission, and a cell encapsulation component.

In some implementations, the cell encapsulation component includes photovoltaic glass, and the photovoltaic glass covers the foregoing solar cell, to protect the solar cell. In addition, the photovoltaic glass has very good transparency and very high stiffness, and can adapt to a very large day-and-night temperature difference and an adverse weather environment.

In some implementations, the cell encapsulation component includes an EVA thin film, disposed between the photovoltaic glass and the solar cell, and configured to bond the photovoltaic glass and the solar cell.

In some implementations, the cell encapsulation component includes a photovoltaic backboard, and the photovoltaic backboard also protects the solar cell.

Optionally, a material of the photovoltaic backboard may be a polyvinyl fluoride composite film or a thermoplastic elastic material. The material of the photovoltaic backboard has characteristics such as insulation, waterproofing, and aging resistance.

In some implementations, the cell encapsulation component includes a solar aluminum frame, which is made of an aluminum alloy, and has characteristics such as high strength and good corrosion resistance. The solar aluminum frame can support and protect the solar cell.

An embodiment of the present application further provides a photovoltaic apparatus, including the photovoltaic module provided in the foregoing embodiment.

In some embodiments, the photovoltaic apparatus may alternatively be a lighting device, an energy storage device, or the like, which is included in, but is not limited to, this embodiment of the present application. For example, the photovoltaic apparatus may be a solar water heater, a solar street light, or a solar photovoltaic power generator.

### [Example]

Examples of the present application are described below. The examples described below are exemplary and are only intended to explain the present application, and cannot be understood as limitations to the present application. If the specific technology or conditions are not specified in the examples, the technology or conditions described in the literature in this field or the product manual shall be followed. The used reagents or instruments without manufacturer indicated are all conventional products that may be purchased in the market.

### 1. Preparation of a solar cell

### [Example 1]

Example 1 corresponds to a structure of the solar cell shown in FIG. 1.

First electrode layer: The first electrode layer was disposed on a glass substrate. A material of the first electrode layer was indium tin oxide (ITO). The glass substrate including the first electrode layer was sequentially washed by using acetone, ethyl alcohol, and deionized water, and was dried and ready for use.

Hole transport layer: 0.3 mg of MeO-4PACz was added to 1 ml of ethanol, followed by stirring. An ethanol solution of MeO-4PACz was spin-coated on the first electrode layer 11 (where a spin-coating rotation speed is 4000 rpm, and spin-coating duration is 30 s), and then was transferred to a hot stage and annealed for 10 min at 100 °C, to form the hole transport layer.

First light absorption layer: 123 mg of CH(NH₂)₂I, 59 mg of CH(NH₂)₂Br, 46 mg of CsI, 25 mg of CsBr, 428 mg of PbI₂, and 209 mg of PbBr₂ were added to 1 mL of solvent in which DMF and DMSO were mixed (where a volume ratio of the DMF to the DMSO was 3:1), and stirring was performed for 2 h at a rotation speed of 600 rpm on a magnetic stirrer, followed by filtering, to prepare a perovskite precursor solution. 100 µL of the perovskite precursor solution was spin-coated at the hole transport layer (spin-coating was performed for 10 s at a spin-coating rotation speed of 2000 rpm, and was then performed for 30 s at a spin-coating rotation speed of 4000 rpm). 250 µL of chlorobenzene was dropped on a spin-coated perovskite precursor solution. The perovskite precursor solution continued to be spin-coated, and then transferred to the hot stage and annealed for 10 min at 100 °C, to form the first light absorption layer.

Interconnection layer: An SnOₓ material was deposited at the first light absorption layer by using an atomic layer deposition (ALD) device, to prepare a layer of 15 nm of SnOₓ, so as to form the interconnection layer. A ratio of an element tin to an element oxygen in the SnOₓ material was adjusted during deposition of the SnOₓ material, and x gradually decreased from 2 to 1 along a direction away from the first light absorption layer.

Second light absorption layer: 216 mg of CH(NH₂)₂I, 85 mg of CH₃NH₂I, 414 mg of PbI₂, 335 mg of SnI₂, and 0.3 mg of MeO-4PACz were added to 1 mL of solvent in which DMF and DMSO were mixed (where a volume ratio of the DMF to the DMSO was 3:1), and stirring was performed for 2 h at a rotation speed of 600 rpm on the magnetic stirrer, followed by filtering, to prepare a perovskite precursor solution. 100 µL of the perovskite precursor solution was spin-coated at the interconnection layer (spin-coating was performed for 10 s at a spin-coating rotation speed of 1000 rpm, and was then performed for 30 s at a spin-coating rotation speed of 4000 rpm). 300 µL of ethyl acetate was dropped on a spin-coated perovskite precursor solution. The perovskite precursor solution continued to be spin-coated, and then transferred to the hot stage and annealed for 10 min at 100 °C, to form the second light absorption layer.

Electron transport layer: A layer of 10 nm of bathocuproine (BCP) was vapor-deposited at the second light absorption layer, to form the electron transport layer.

Second electrode layer: A layer of 100 nm of metal copper (Cu) was vapor-deposited at the electron transport layer, to form the second electrode layer. The solar cell of Example 1 was finally prepared.

### [Examples 2 to 6]

Preparation in Examples 2 to 6 is similar to that in Example 1, and a difference lies in that thicknesses of SnOₓ layers in Examples 2 to 6 are respectively 1 nm, 5 nm, 20 nm, 200 nm, and 250 nm.

### [Example 7]

Preparation in Example 7 is similar to that in Example 1, and a difference lies in that the interconnection layer is prepared by using a different method. In Example 7, a layer of 8 nm of SnO₂ layer is prepared at the first light absorption layer by using the ALD device, a layer of 5 nm of SnO_{1.77} layer is prepared at the SnO₂ layer, and a layer of 15 nm of SnO layer is finally prepared at the SnO_{1.77} layer, to form the interconnection layer.

### [Examples 8 to 13]

Preparation in Examples 8 to 13 is similar to that in Example 7, and a difference lies in that thicknesses of SnO₂ layers in Examples 8 to 13 are respectively 1 nm, 5 nm, 10 nm, 50 nm, 0.1 nm, and 60 nm.

### [Examples 14 to 19]

Preparation in Examples 14 to 19 is similar to that in Example 7, and a difference lies in that thicknesses of SnO_{1.77} layers in Examples 14 to 19 are respectively 1 nm, 2 nm, 8 nm, 50 nm, 0.1 nm, and 60 nm.

### [Examples 20 to 25]

Preparation in Examples 20 to 25 is similar to that in Example 7, and a difference lies in that thicknesses of SnO layers in Examples 20 to 25 are respectively 1 nm, 5 nm, 20 nm, 50 nm, 0.1 nm, and 60 nm.

### [Example 26]

Preparation of the first electrode layer, the hole transport layer, the first light absorption layer, the interconnection layer, the second light absorption layer, the electron transport layer, and the second electrode layer in Example 26 is similar to that in Example 1, and a difference lies in that, in Example 26, a first hole barrier layer is disposed between the first light absorption layer and the SnOₓ layer, and a second hole barrier layer is disposed between the second light absorption layer and the electron transport layer. Specifically, a layer of 25 nm of C60 was vapor-deposited at the first light absorption layer, to form the first hole barrier layer, and then the SnOₓ layer was prepared at the first hole barrier layer (for a preparation process of the SnOₓ layer, refer to Example 1). A layer of 25 nm of C60 was vapor-deposited at the second light absorption layer, to form the second hole barrier layer, and then the electron transport layer was prepared at the second hole barrier layer (for a preparation process of the electron transport layer, refer to Example 1).

### [Example 27]

Preparation in Example 27 is similar to that in Example 1, and a difference lies in that a material of the second light absorption layer is monocrystalline silicon in Example 27. Preparation of the second light absorption layer: The monocrystalline silicon was washed and textured by using strong alkali, to obtain two textured surfaces. A layer of 5 nm of intrinsic i-type amorphous silicon and a layer of 100 nm of doped p-type amorphous silicon were respectively prepared, by using plasma enhanced chemical vapor deposition (PECVD) device, on one side of a monocrystalline silicon wafer with two surface textured, and then a layer of 5 nm of intrinsic i-type amorphous silicon and a layer of 100 nm of doped N-type amorphous silicon were respectively prepared on the other side by using the same PECVD device. A layer of 100 nm of ITO was respectively prepared, by using a physical vapor deposition (PVD) device, on both sides of a sample on which the amorphous silicon was completely prepared, to prepare the second light absorption layer.

### [Comparative examples 1 and 2]

Preparation in Comparative examples 1 and 2 is similar to that in Example 1, and a difference lies in that an interconnection layer in Comparative example 1 includes only the SnO₂ layer, and an interconnection layer in Comparative example 2 includes only the SnO_{1.77} layer.

Next, a process of testing performance of the solar cell is described.

### 2. Performance test of the solar cell

Performance of cells was tested under radiation of standard simulated sunlight (AM 1.5G, 100 mW/cm²), to obtain I-V curves. Short-circuit currents Jsc (in mA/cm²), open-circuit voltages Voc (in V), maximum light output currents Jmpp (in mA), and maximum light output voltages Vmpp (in V) can be obtained based on the I-V curves and data fed back by a test device. Fill factors FF of the cells were calculated using the formula FF = Jsc × Voc / (Jmpp × Vmpp), in %. Photoelectric conversion efficiency PCE of the batteries was calculated using the formula PCE = Jsc × Voc × FF / Pin, in %, where Pin represented an input power of incident light, in mW.

Performance of cells prepared in Examples 1 to 27 and Comparative examples 1 and 2 were respectively tested by using the foregoing method. For detailed test results, refer to Table 1 and Table 2. In Table 1, d1 represents a thickness of the SnOₓ layer. In table 2, d2 represents a thickness of the SnO₂ layer, d3 represents a thickness of the SnO_{1.77} layer, and d4 represents a thickness of the SnO layer.

**Table 1: Product parameters of performance test results of Examples 1 to 6 and 26 and 27, and Comparative examples 1 and 2.**

| Serial number | Interconnection layer | | First light absorption layer | Whether a barrier layer is disposed | Fill factor FF /% | Efficiency PCE / % |
|---|---|---|---|---|---|---|
| | Material | d1 / mn | | | | |
| Example 1 | SnOₓ (1 ≤ x ≤ 2) | 15 | Perovskite | No | 82.2% | 24.5% |
| Example 2 | SuOₓ (1 ≤ x ≤ 2) | 1 | Perovskite | No | 75.1% | 22.4% |
| Example 3 | SnOₓ (1 ≤ x ≤ 2) | 5 | Perovskite | No | 79.1% | 23.3% |
| Example 4 | SnOₓ (1 ≤ x ≤ 2) | 20 | Perovskite | No | 81.5% | 24.0% |
| Example 5 | SnOₓ (1 ≤ x ≤ 2) | 200 | Perovskite | No | 77.4% | 22.8% |
| Example 6 | SnOₓ (1 ≤ x ≤ 2) | 250 | Perovskite | No | 73.8% | 21.7% |
| Example 26 | SnOₓ (1 ≤ x ≤ 2) | 15 | Perovskite | Yes | 82.3% | 25.1% |
| Example 27 | SnOₓ (1 ≤ x ≤ 2) | 15 | Monocrystalline silicon | No | 81.5% | 24.0% |
| Comparative example 1 | SnO_{1.77} | 10 | Perovskite | No | 69.9% | 21.0% |
| Comparative example 2 | SnO₂ | 10 | Perovskite | No | 68.2% | 20.5% |

**Table 2: Product parameters of performance test results of Examples 7 to 25 and Comparative examples 1 and 2**

| Serial number | Interconnection layer | | | Fill factor FF /% | Efficiency PCE / % |
|---|---|---|---|---|---|
| | d2 / nm | d3 / nm | d4 / nm | | |
| Example 7 | 8 | 5 | 15 | 82.5% | 24.7% |
| Example 8 | 1 | 5 | 15 | 78.4% | 23.1% |
| Example 9 | 5 | 5 | 15 | 82.2% | 24.5% |
| Example 10 | 10 | 5 | 15 | 82.5% | 24.3% |
| Example 11 | 50 | 5 | 15 | 79.8% | 23.5% |
| Example 12 | 0.1 | 5 | 15 | 75.4% | 22.2% |
| Example 13 | 60 | 5 | 15 | 75.7% | 22.3% |
| Example 14 | 8 | 1 | 15 | 79.1% | 23.3% |
| Example 15 | 8 | 2 | 15 | 81.5% | 24.0% |
| Example 16 | 8 | 8 | 15 | 81.8% | 24.1% |
| Example 17 | 8 | 50 | 15 | 78.4% | 23.1% |
| Example 18 | 8 | 0.1 | 15 | 74.7% | 22.0% |
| Example 19 | 8 | 60 | 15 | 76.4% | 22.5% |
| Example 20 | 8 | 5 | 1 | 79.8% | 23.5% |
| Example 21 | 8 | 5 | 5 | 81.5% | 24.2% |
| Example 22 | 8 | 5 | 20 | 81.8% | 24.1% |
| Example 23 | 8 | 5 | 50 | 78.8% | 23.2% |
| Example 24 | 8 | 5 | 0.1 | 74.9% | 22.1% |
| Example 25 | 8 | 5 | 60 | 75.4% | 22.2% |
| Comparative example 1 | 10 | / | / | 69.9% | 21.0% |
| Comparative example 2 | / | 10 | / | 68.2% | 20.5% |

It can be learned from comparison between the results of Examples 1 to 25 and Comparative examples 1 and 2 that, when the interconnection layer between the first light absorption layer and the second light absorption layer includes a plurality of types of oxides of tin, and x in the SnOₓ layer at the interconnection layer decreases from 2 to 1 along a direction of the first light absorption layer and the second light absorption layer, efficiency of the solar cell is obviously improved.

It can be learned from comparison between the results of Examples 1 to 6 that, when the thickness of the SnOₓ layer is set to a proper range, the efficiency of the solar cell is more obviously improved. When other conditions are the same, when the thickness of the SnOₓ layer is set to a range from 1 nm to 200 nm, the efficiency of the solar cell is more obviously improved.

It can be learned from comparison between the results of Examples 7 to 13 that, when the thickness of the SnO₂ layer is set to a proper range, the efficiency of the solar cell is more obviously improved. When other conditions are the same, when the thickness of the SnO₂ layer is set to a range from 1 nm to 50 nm, the efficiency of the solar cell is more obviously improved.

It can be learned from comparison between the results of Examples 7 and 14 to 19 that, when the thickness of the SnO_{1.77} layer is set to a proper range, the efficiency of the solar cell is more obviously improved. When other conditions are the same, when the thickness of the SnO_{1.77} layer is set to a range from 1 nm to 50 nm, the efficiency of the solar cell is more obviously improved.

It can be learned from comparison between the results of Examples 7 and 20 to 25 that, when the thickness of the SnO layer is set to a proper range, the efficiency of the solar cell is more obviously improved. When other conditions are the same, when the thickness of the SnO layer is set to a range from 1 nm to 50 nm, the efficiency of the solar cell is more obviously improved.

It can be learned from comparison between the results of Example 1 and Example 26 that disposition of the hole barrier layer between the light absorption layer and the electron transport layer helps improve the efficiency of the solar cell.

It should be noted that the present application is not limited to the foregoing implementations. The foregoing implementations are merely examples, and any implementation within the scope of the technical solutions of the present application that has substantially the same composition and has the same effects as the technical idea is encompassed in the technical scope of the present application. In addition, without departing from the gist of the present application, various modifications that may be conceived by those skilled in the art to the implementations, and other modes constructed by combining some of the constituent elements of the implementations are also encompassed in the scope of the present application.

## Claims

1. A solar cell, comprising:
a first electrode layer, a hole transport layer, a first light absorption layer, an interconnection layer, a second light absorption layer, an electron transport layer, and a second electrode layer that are sequentially arranged along a first direction, wherein
the interconnection layer comprises an SnOₓ layer, the SnOₓ layer comprises at least three types of SnOₓ materials, and x gradually decreases from 2 to 1 along the first direction.

2. The solar cell according to claim 1, wherein a thickness d1 of the SnOₓ layer satisfies: 1 nm ≤ d1 ≤ 200 nm.

3. The solar cell according to claim 2, wherein the thickness d1 of the SnOₓ layer satisfies: 5 nm ≤ d1 ≤ 20 nm.

4. The solar cell according to any one of claims 1 to 3, wherein the SnOₓ layer comprises an SnO₂ layer, an SnO_{y} layer, and an SnO layer, the SnO_{y} layer is located between the SnO₂ layer and the SnO layer, the SnO layer is located between the SnO_{y} layer and the second light absorption layer, and y satisfies: 1 < y < 2.

5. The solar cell according to claim 4, wherein a thickness d2 of the SnO₂ layer satisfies: 1 nm ≤ d2 ≤ 50 nm.

6. The solar cell according to claim 5, wherein the thickness d2 of the SnO₂ layer satisfies: 5 nm ≤ d2 ≤ 10 nm.

7. The solar cell according to any one of claims 4 to 6, wherein a thickness d3 of the SnO_{y} layer satisfies: 1 nm ≤ d3 ≤ 50 nm.

8. The solar cell according to claim 7, wherein the thickness d3 of the SnO_{y} layer satisfies: 2 nm ≤ d3 ≤ 8 nm.

9. The solar cell according to any one of claims 4 to 8, wherein a thickness d4 of the SnO layer satisfies: 1 nm ≤ d4 ≤ 50 nm.

10. The solar cell according to claim 9, wherein the thickness d4 of the SnO layer satisfies: 5 nm ≤ d4 ≤ 20 nm.

11. The solar cell according to any one of claims 1 to 10, wherein the interconnection layer further comprises a first hole barrier layer, and the first hole barrier layer is located between the first light absorption layer and the SnOₓ layer.

12. The solar cell according to any one of claims 1 to 11, wherein the solar cell further comprises a second hole barrier layer, and the second hole barrier layer is located between the second light absorption layer and the electron transport layer.

13. The solar cell according to any one of claims 1 to 12, wherein a material of the first electrode layer comprises a transparent conductive oxide, and the transparent conductive oxide comprises at least one of indium tin oxide, zinc gallium oxide, indium oxide doped with lanthanide metal, tin oxide doped with fluorine, tungsten oxide doped with indium, zinc oxide doped with indium, zinc oxide doped with boron, and zinc oxide doped with aluminum.

14. The solar cell according to any one of claims 1 to 13, wherein a material of the hole transport layer comprises a P-type semiconductor, and a material of the electron transport layer comprises an N-type semiconductor.

15. The solar cell according to claim 14, wherein the material of the hole transport layer comprises at least one of the following materials and derivatives thereof: [4-(3,6-dimethoxy-9H-carbazol-9-yl)butyl]phosphonic acid, [2-(3,6-dimethoxy-9H-carbazol-9-yl)ethyl]phosphonic acid, [4-(3,6-dibromo-9H-carbazol-9-yl)butyl]phosphonic acid, poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazol-spirobifluorene, poly(3,4-ethylenedioxythiophene)-poly(styrenesulfonate), polythiophene, nickel oxide, molybdenum oxide, cuprous iodide, and cuprous oxide; and
the material of the electron transport layer comprises at least one of the following materials and derivatives thereof: bathocuproine, [6,6]-phenyl-C61-butyric acid methyl ester, [6,6]-phenyl-C71-butyric acid methyl ester, C60, C70, SnO_{z} (1.5 ≤ z ≤ 2), and zinc oxide.

16. The solar cell according to any one of claims 1 to 15, wherein a material of the first light absorption layer is perovskite, and a material of the second light absorption layer is perovskite.

17. The solar cell according to claim 16, wherein the first direction is an incident direction of sunlight, and a band gap of the material of the first light absorption layer is greater than a band gap of the material of the second light absorption layer.

18. The solar cell according to claim 17, wherein a chemical formula of the perovskite in the first light absorption layer and the second light absorption layer is ABX₃, wherein
A comprises at least one of CH₃(NH₂)₂⁺, CH(NH₂)₂⁺, CH₃NH₂⁺, Li⁺, Na⁺, K⁺, Rb⁺, and Cs⁺, B comprises at least one of Pb⁺, Be²⁺, Mg²⁺, Ca²⁺, Sr²⁺, Ba²⁺, Zn²⁺, Ge²⁺, Fe²⁺, Co²⁺, and Ni²⁺, and X comprises at least one of Cl⁻, Br⁻, I⁻, SCN⁻, CNO⁻, OCN⁻, OSCN⁻, SH⁻, OH⁻, CP⁻, CN⁻, SeCN⁻, N₃⁻, and NO₂⁻.

19. The solar cell according to any one of claims 1 to 18, wherein the second electrode layer comprises metal, and the metal comprises at least one of gold, silver, copper, aluminum, nickel, chromium, bismuth, platinum, magnesium, molybdenum, tungsten, and alloys thereof.

20. The solar cell according to claim 11, wherein the first hole barrier layer comprises at least one of fullerene and a derivative thereof, and SnO_{z} (1.5 ≤ z ≤ 2).

21. The solar cell according to claim 12, wherein the second hole barrier layer comprises at least one of fullerene and a derivative thereof, and SnO_{z} (1.5 ≤ z ≤ 2).

22. A preparation method of a solar cell, wherein the method comprises:
providing a first electrode layer, a hole transport layer, a first light absorption layer, an interconnection layer, a second light absorption layer, an electron transport layer, and a second electrode layer that are sequentially arranged along a first direction, wherein
the interconnection layer comprises an SnOₓ layer, the SnOₓ layer comprises at least three types of SnOₓ materials, and x gradually decreases from 2 to 1 along the first direction.

23. The preparation method according to claim 22, wherein the providing a first electrode layer, a hole transport layer, a first light absorption layer, an interconnection layer, a second light absorption layer, an electron transport layer, and a second electrode layer that are sequentially arranged along a first direction comprises:
providing the first electrode layer;
preparing the hole transport layer at the first electrode layer;
preparing the first light absorption layer at the hole transport layer;
preparing the interconnection layer at the first light absorption layer;
preparing the second light absorption layer at the interconnection layer;
preparing the electron transport layer at the second light absorption layer; and
preparing the second electrode layer at the electron transport layer.

24. The preparation method according to claim 23, wherein the preparing the interconnection layer at the first light absorption layer comprises:
preparing the SnOₓ layer at the first light absorption layer, to form the interconnection layer.

25. The preparation method according to claim 24, wherein the preparing the SnOₓ layer at the first light absorption layer comprises:
preparing an SnO₂ layer at the first light absorption layer, preparing an SnO_{y} layer (1 < y < 2) at the SnO₂ layer, and preparing an SnO layer at the SnO_{y} layer, to prepare the SnOₓ layer.

26. The preparation method according to claim 24, wherein the preparing the SnOₓ layer at the first light absorption layer comprises:
depositing an SnOₓ (1 ≤ x ≤ 2) material at the first light absorption layer by using an atomic layer deposition device, to prepare the SnOₓ layer, wherein
a ratio of an element tin to an element oxygen in the SnOₓ material is adjusted during deposition of the SnOₓ material, and x gradually decreases from 2 to 1 along the first direction.

27. The preparation method according to any one of claims 22 to 26, wherein a thickness d1 of the SnOₓ layer satisfies: 1 nm ≤ d1 ≤ 200 nm.

28. The preparation method according to claim 27, wherein the thickness d1 of the SnOₓ layer satisfies: 5 nm ≤ d1 ≤ 20 nm.

29. The preparation method according to claim 25, wherein a thickness d2 of the SnO₂ layer satisfies: 1 nm ≤ d2 ≤ 50 nm.

30. The preparation method according to claim 29, wherein the thickness d2 of the SnO₂ layer satisfies: 5 nm ≤ d2 ≤ 10 nm.

31. The preparation method according to claim 25, wherein a thickness d3 of the SnO_{y} layer satisfies: 1 nm ≤ d3 ≤ 50 nm.

32. The preparation method according to claim 31, wherein the thickness d3 of the SnO_{y} layer satisfies: 2 nm ≤ d3 ≤ 8 nm.

33. The preparation method according to claim 25, wherein a thickness d4 of the SnO layer satisfies: 1 nm ≤ d4 ≤ 50 nm.

34. The preparation method according to claim 33, wherein the thickness d4 of the SnO layer satisfies: 5 nm ≤ d4 ≤ 20 nm.

35. A photovoltaic module, comprising the solar cell according to any one of claims 1 to 21, and/or a solar cell prepared by using the preparation method according to any one of claims 22 to 34.

36. A photovoltaic apparatus, comprising the photovoltaic module according to claim 35.
